(19) Europäisches Patentamt
European Patent Office
Office européen des brevets

(11) **EP 2 848 594 A1**

(12) **EUROPEAN PATENT APPLICATION**
published in accordance with Art. 153(4) EPC

(43) Date of publication:
**18.03.2015 Bulletin 2015/12**

(21) Application number: **13787984.7**

(22) Date of filing: **25.04.2013**

(51) Int Cl.:
*C03C 3/087* (2006.01)  *B32B 17/06* (2006.01)
*C03C 3/085* (2006.01)  *C03C 3/091* (2006.01)
*G02B 5/08* (2006.01)  *G02B 5/10* (2006.01)

(86) International application number:
**PCT/JP2013/062275**

(87) International publication number:
**WO 2013/168592 (14.11.2013 Gazette 2013/46)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **11.05.2012  JP 2012110088**
**11.05.2012  JP 2012110089**
**14.02.2013  JP 2013026354**

(71) Applicant: **Asahi Glass Company, Limited**
**Tokyo 100-8405 (JP)**

(72) Inventors:
• **SASAI, Jun**
**Tokyo 100-8405 (JP)**
• **ONO, Kazutaka**
**Tokyo 100-8405 (JP)**

• **NAKASHIMA, Tetsuya**
**Tokyo 100-8405 (JP)**
• **ABE, Keisuke**
**Tokyo 100-8405 (JP)**
• **KAMEYAMA, Yasuyuki**
**Tokyo 100-8405 (JP)**
• **SATO, Nana**
**Tokyo 100-8405 (JP)**
• **KATO, Yasumasa**
**Tokyo 100-8405 (JP)**
• **FUKAMI, Masao**
**Tokyo 100-8405 (JP)**
• **MITARAI, Kazuhiko**
**Tokyo 100-8405 (JP)**

(74) Representative: **Müller-Boré & Partner**
**Patentanwälte PartG mbB**
**Friedenheimer Brücke 21**
**80639 München (DE)**

(54) **FRONT GLASS PLATE FOR LAMINATED BODY, AND LAMINATED BODY**

(57)    A front glass plate for a stacked structure includes greater than or equal to 5 mol% of $Al_2O_3$, in terms of an oxide, as a component, 50% crack initiation load of the front glass plate being greater than or equal to 0.5 kg.

FIG.1

EP 2 848 594 A1

**Description**

BACKGROUND OF THE INVENTION

1. Field of the Invention

The present invention relates to a front glass plate for a stacked structure and a stacked structure including such a front glass plate.

2. Description of the Related Art

A reflector that includes a front glass plate, a second glass plate and a reflection layer provided therebetween is widely used in various fields. In particular, recently, a reflector having high reflectance is noticed and developed to be used in a solar thermal power generation apparatus or the like, for example.

In such a reflector, in order to actualize the high reflectance, it is required for the front glass plate to have high transparency. For example, Patent Document 1 discloses a structure in which a front glass plate of a reflector used in a solar thermal power generation apparatus is thinly formed as about 0.5 mm to 2.5 mm, for example.

[Patent Document]

[Patent Document 1] US Patent No. 7,871,664

By making the front glass plate to be thin, it is expected that the transparency of the front glass plate is increased and the reflectance of the reflector is increased. However, there is a possibility that durability of the reflector is decreased just by making the front glass plate to be thin. In particular, if a thin front glass plate is used, mechanical characteristics of the front glass plate may be decreased. For example, assuming that a reflector including a thin front glass plate is used outdoors, erosion of the front glass plate caused by blowing of sands, dust or the like may be a problem.

Further, for example, in the reflector including the front glass plate, a problem of so-called "blur" phenomenon (dimming, staining or the like) may occur. The "blur" phenomenon means that the front glass plate is chemically altered in a progression of a long period due to liquid such as water or the like adhering to the front glass plate. If such a "blur" phenomenon occurs, the transmittance of the front glass plate is significantly lowered to cause lowering of the reflectance of the reflector.

However, Patent Document 1 does not disclose any measures to take for such a chemical deterioration problem of the front glass plate. In particular, generally, a solar thermal power generation apparatus is often provided at a place with strong sunshine such as a desert region or the like, and in such a case, the "blur" phenomenon may occur within a shorter period due to the high temperature of the front glass plate.

Further, such problems regarding the erosion and the "blur" phenomenon are not limited to the reflector. For example, similar problems regarding the erosion and the "blur" phenomenon can happen to various stacked structure products including the front glass plate such as a building window glass, a vehicle window glass, a cover glass for a solar photovoltaic module or the like, for example.

SUMMARY OF THE INVENTION

The present invention is made in light of the above problems, and provides a front glass plate for a stacked structure in which mechanical and chemical characteristics are improved compared with a conventional one. Further, the present invention provides a stacked structure including such a front glass plate.

According to an embodiment, there is provided a front glass plate for a stacked structure, the front glass plate including:

greater than or equal to 5 mol% of $Al_2O_3$, in terms of an oxide, as a component,
50% crack initiation load of the front glass plate being greater than or equal to 0.5 kg.

According to another embodiment, there is provided a stacked structure including the front glass plate having such features, and a functional component provided at a back surface of the front glass plate.

According to the invention, a front glass plate for a stacked structure in which mechanical and chemical characteristics are improved compared with a conventional one can be provided. Further, according to the invention, a stacked structure including such a front glass plate can be provided.

BRIEF DESCRIPTION OF THE DRAWINGS

Fig. 1 is a cross-sectional view illustrating an example of an outline of a structure of a reflector including a front glass plate of an embodiment;

Fig. 2 is a top view schematically illustrating a state after a diamond indenter is pushed toward a sample and a load is removed;

Fig. 3 is a flowchart illustrating an example of an outline of a method of manufacturing the reflector;

Fig. 4 is a view illustrating an example of an outline of a structure of a vehicle window including the front glass plate of the embodiment;

Fig. 5 is a view illustrating an example of an outline of a structure of a solar photovoltaic module including the front glass plate of the embodiment;

Fig. 6 is a graph illustrating a measurement result of transmittance of each glass sample of examples 3, 5 and 6;

Fig. 7 is an enlarged graph of a part of the graph illustrated in Fig. 6 at wavelength from 300 nm to 400 nm;

Fig. 8 is a graph illustrating a relationship between a sand blast process period and a haze value of each glass sample of examples 1 to 4;

Fig. 9 is a graph illustrating a relationship between a retained period at high temperature in a high humidity environment and a haze value of each of the glass samples of examples 1 to 4;

Fig. 10 is a graph illustrating a relationship between a retained period at high temperature in a high humidity environment and a haze value of each glass sample of examples 5 and 6;

Fig. 11 is a graph illustrating a measurement result of transmittance of each glass sample of examples 7 to 9; and

Fig. 12 is an enlarged graph of a part of the graph illustrated in Fig. 11 at wavelength from 300 nm to 400 nm.

DETAILED DESCRIPTION OF THE PREFERRED EMBODIMENTS

The invention will be described herein with reference to illustrative embodiments. Those skilled in the art will recognize that many alternative embodiments can be accomplished using the teachings of the present invention and that the invention is not limited to the embodiments illustrated for explanatory purposes.

In this embodiment, a front glass plate for a stacked structure is provided which has features including greater than or equal to 5 mol% $Al_2O_3$, in terms of an oxide, as a component, 50% crack initiation load of the front glass plate being greater than or equal to 0.5 kg.

As will be described in detail later, mechanical and chemical characteristics of the front glass plate having such features are significantly improved compared with a conventional one. Thus, by adopting the front glass plate having such features, a stacked structure in which mechanical and chemical characteristics are improved can be provided.

In the following, features of a front glass plate of an embodiment is explained with reference to specific examples of various stacked structures including the front glass plate of the embodiment.

(Reflector)

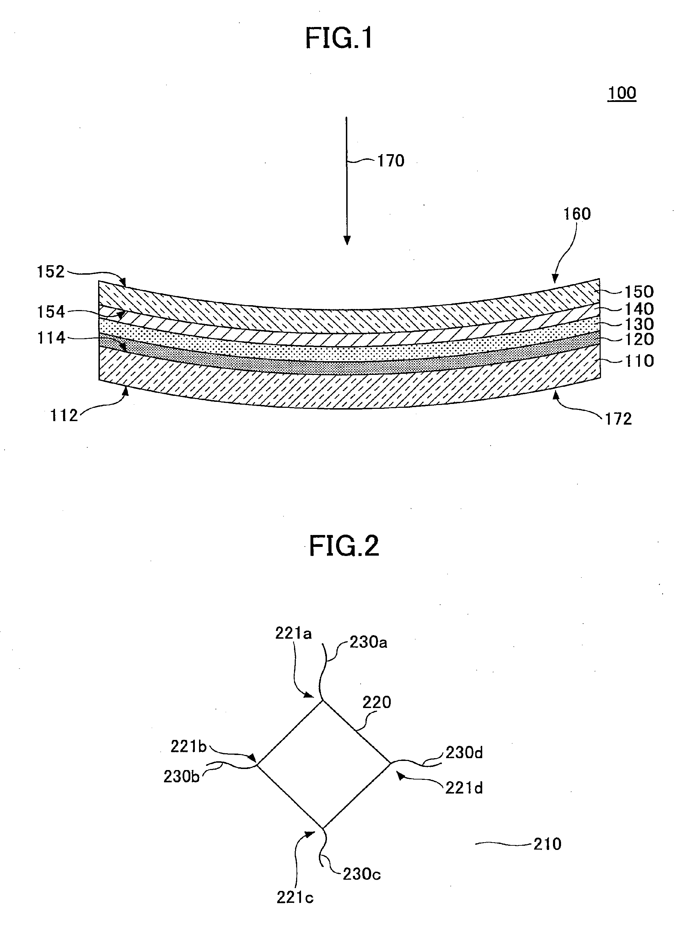

Fig. 1 illustrates an example of an outline of a structure of a reflector including a front glass plate of the embodiment.

As illustrated in Fig. 1, the reflector 100 including the front glass plate of the embodiment is configured by stacking a support glass plate 110, an adhesion layer 120, a protection layer 130, a reflection layer 140 and the front glass plate 150 in this order.

The front glass plate 150 is provided with a first surface 152 that is at a further side from the support glass plate 110 and a second surface 154 that is at a closer side from the support glass plate 110. The support glass plate 110 is provided with a third surface 112 that is at a further side from the front glass plate 150 and a fourth surface 114 that is at a closer side from the front glass plate 150. The support glass plate 110 has a function to support components that are mounted on the support glass plate 110.

The reflection layer 140 is generally configured by a layer including metal such as silver or the like, and provides a reflection function to the reflector 100.

The protection layer 130 is provided to protect the reflection layer 140. Alternatively, the protection layer 130 may be omitted.

The front glass plate 150 has a function to support the reflection layer 140 and to form a light incident surface 160 of the reflector 100. Generally, the reflection layer 140 is formed on a surface (the second surface 154 in the example of Fig. 1) of the front glass plate 150.

The adhesion layer 120 has a function to bond the support glass plate 110 and the front glass plate 150 on which the reflection layer 140 (and the protection layer 130, if necessary) is formed.

The reflector 100 has a curved surface shape, in other words, a concave shape protruding downward, in the example of Fig. 1. However, the reflector 100 may not necessarily have this shape and the reflector 100 may have a flat shape, for example.

In the reflector 100 configured as such, when incident light 170 is irradiated on the light incident surface 160, the incident light 170 transmits through the front glass plate 150 and reaches the reflection layer 140. The incident light 170 that reached the reflection layer 140 is reflected by the reflection layer 140. The reflected light then progresses through the front glass plate 150 in an opposite direction and is emitted from the reflector 100 via the light incident surface 160 to focus at a desired position.

For example, when the reflector 100 is used in a solar thermal power generation apparatus, the reflected light from the reflector 100 is concentrated on a heat storage member that absorbs solar energy as heat energy. Thereafter, electric power can be generated by generating a high temperature and high pressure steam using the heat energy accumulated in the heat storage member.

Here, the above described Patent Document 1 discloses a technique to make the front glass plate used in the reflector thin to increase the transparency in order to increase the reflectance of the reflector as a whole.

However, when such a front glass plate is used, the mechanical and chemical characteristics of the front glass plate are lowered and the durability of the reflector may be a problem.

For example, when it is assumed that a reflector including a thin front glass plate is adopted in a solar thermal power generation apparatus that is provided outdoors, erosion of the glass plate caused by blowing of sands, dust or the like may be a problem.

Further, for example, in the reflector including the front glass plate, a problem so-called "blur" phenomenon may occur. The "blur" phenomenon means that the front glass plate is chemically altered in a progression of a long period due to liquid such as water or the like adhering to the front glass plate. If such a "blur" phenomenon occurs, the transmittance of the front glass plate is significantly lowered to cause lowering of the reflectance of the reflector. In particular, generally, a solar thermal power generation apparatus is often provided at a place with strong sunshine such as a desert region or the like, and in such a case, the "blur" phenomenon may occur within a shorter period due to the high temperature of the front glass plate.

Meanwhile, as described above, the front glass plate 150 used in the reflector 100 has the following features, (1) including greater than or equal to 5 mol% $Al_2O_3$, in terms of an oxide, as a component; and (2) 50% crack initiation load is greater than or equal to 0.5 kg.

The front glass plate 150 having these features can increase the mechanical and chemical characteristics compared with a conventional one as will be explained below. Thus, in this embodiment, the reflector 100 in which the mechanical and chemical characteristics are improved compared with a conventional one can be provided.

Hereinafter, each of the features (1) and (2) and their advantages of the front glass plate 150 are explained in detail.

For the feature (1)

Generally, alumina ($Al_2O_3$) has a function to increase a chemical stability of a glass. In this embodiment, the front glass plate 150 includes greater than or equal to 5 mol% alumina ($Al_2O_3$), in terms of an oxide, as a glass component. With this configuration, it is possible for the front glass plate 150 to have a relatively good chemical stability.

The content of alumina ($Al_2O_3$) may be within a range of greater than or equal to 5 mol% and less than or equal to 20 mol%, for example.

For the feature (2)

First, definition of "50% crack initiation load", that is one of indicators of physical properties used in this embodiment, is explained.

The "50% crack initiation load" may be measured by the following method.

First, a front glass plate sample (hereinafter, simply referred to as a "sample") is mounted on a stage of a Vickers hardness meter. Next, a diamond shaped diamond indenter is pushed toward a first place of the sample with a predetermined load for 15 seconds.

Fig. 2 illustrates a state after the diamond indenter is pushed toward a sample 210 and a load is removed. As illustrated in Fig. 2, after removing the load, a diamond shaped indentation 220 is formed at a surface of the sample 210. The indentation 220 has four corner portions 221a, 221b, 221c and 221d.

Then, whether cracks are produced at the corner portions 221a to 221d of the indentation 220 is observed. Then, a production rate of cracks $K_1$ (%) at the first place is calculated by the following equation (1).

$$\text{production rate of cracks } K_1(\%) \text{ at the first place}$$

$$= \text{(the number "N" of the corner portions at which}$$

cracks are produced) /

$$\text{(the total number "T" of the corner portions of}$$

$$\text{the indentation 220)} \times 100 \qquad (1)$$

For example, in the example of Fig. 2, cracks 230a to 230d are produced at the corner portions 221a to 221d of the indentation 220, respectively. Thus, the number "N" of the corner portions at which cracks are produced becomes four. Further, the total number "T" of the corner portions of the indentation 220 is four. Thus, the production rate of cracks at the first place becomes $K_1 = 100$ %.

Further, for example, if no cracks are produced at any of the corner portions 221a to 221d of the indentation 220, the production rate of cracks at the first place becomes $K_1 = 0$ %.

Such a measurement is performed on different 20 places of the same sample 210. By averaging the production rates of cracks $K_1$ to $K_{20}$ obtained at the 20 places, respectively, an average production rate of cracks $K_{ave}$ (%) can be obtained.

A load by which the average production rate of cracks $K_{ave}$ (%) calculated as such becomes 50 % is defined as the "50% crack initiation load".

Further, as the "50% crack initiation load" is influenced by temperature and humidity, the measurement is performed under an environment in which temperature is 25 °C and humidity is 20 %.

Such "50% crack initiation load" can be used as an indicator of the fragility of a sample. In other words, when the "50% crack initiation load" is large, cracking is hardly produced even when a large load is applied, in other words, the sample is more "not fragile". When the "50% crack initiation load" is small, cracking is easily produced even when a small load is applied, in other words, the sample is more "fragile".

In this embodiment, the front glass plate 150 has a feature that the indicator of "50% crack initiation load" is greater than or equal to 0.5 kg. Thus, the front glass plate 150 can have the mechanical characteristics higher than a conventional front glass plate.

As described above, in this embodiment, due to the above described features (1) and (2), the front glass plate 150 in which the mechanical and chemical characteristics are improved, compared with a conventional one, can be provided. Further, with this, in this embodiment, the reflector 100 in which the mechanical and chemical characteristics are improved, compared with a conventional one, can be provided.

(Each component of reflector)

Next, each component of the reflector 100 illustrated in Fig. 1 is explained in detail.

(Front glass plate 150)

The front glass plate 150 of the embodiment may be configured by any types of glass provided that the front glass plate 150 has the above described features (1) and (2).

The thickness of the front glass plate 150 may be within a range of greater than or equal to 0.1 mm and less than or equal to 1 mm, for example.

The front glass plate 150 may be made of a $SiO_2$-based glass such as aluminosilicate, borosilicate, soda-lime or the like, or a $P_2O_5$-based glass, for example.

As described above, in this embodiment, the front glass plate 150 includes greater than or equal to 5 mol% alumina ($Al_2O_3$), in terms of an oxide. By setting the content of alumina to be greater than or equal to 5 mol%, the chemical durability is increased and the effect of suppressing the "blur" phenomenon can be increased. Thus, it is preferable that the content of alumina is greater than or equal to 5 mol%. On the other hand, by setting the content of alumina less than or equal to 20 mol%, fragility can be kept low and erosion durability can be appropriately retained. Further, by setting the content of alumina less than or equal to 20 mol%, becoming too much high viscosity at a high temperature can be prevented and also lowering of quality such as generation of bubbles, non-melt raw materials or the like can be prevented, when manufacturing a glass plate. Thus, it is preferable that the content of alumina is less than or equal to 20 mol%.

Further, the front glass plate 150 may include magnesium oxide (MgO). In such a case, the content of magnesium oxide may be within a range of 5 mol% to 15 mol%. Further, the front glass plate 150 may include boron oxide ($B_2O_3$).

In such a case, the content of boron oxide may be within a range of 2 mol% to 12 mol%.

By adding magnesium oxide and/or boron oxide, the erosion durability of the front glass plate 150 is improved.

Further, the front glass plate 150 of the embodiment may have energy transmittance greater than or equal to 90.4 %. Here, the "energy transmittance" means total solar energy transmittance defined by ISO9050:2003(E).

Further, a haze value of the front glass plate 150 after being performed with a sand blast process for three seconds may be less than or equal to 15 %.

The condition of the sand blast process of the embodiment is as follows:

medium; alumina medium of particle size #80,
pressure; 1 kg / cm$^2$,
distance between a sample and a blast gun; 35 cm, and
injected angle of the medium; substantially perpendicular to the sample.

On the other hand, the "haze value" is one of indicators to express transparency of a sample, and is used when expressing turbidity (opacity) of the sample. In this embodiment, the "haze value" is a value obtained by a haze meter.

Here, in order to increase the reflectance of the reflector 100, it is effective to improve the transmittance of the front glass plate 150. Thus, the front glass plate 150 may have the energy transmittance higher than that of the support glass plate 110, and/or may be formed to be thinner than the support glass plate 110. By adopting these features, the transmittance of the front glass plate 150 can be improved and the reflectance of the reflector 100 can be increased.

Further, the content of sodium (Na) at the first surface 152 of the front glass plate 150 may be suppressed (reduced) compared with the content of sodium (Na) at the third surface 112 of the support glass plate 110.

Sodium that exists at an outermost surface of the reflector 100, in other words, at the first surface 152 of the front glass plate 150 has a large influence on the above described "blur" phenomenon. In other words, if the content of sodium that exists at an outermost surface of a glass plate increases, the "blur" phenomenon significantly occurs because an ion-exchange reaction between sodium ion in the glass and water species in environment (hydrogen ion, for example) easily occurs.

Thus, by decreasing the content of sodium at the first surface 152 of the front glass plate 150, the "blur" phenomenon hardly occurs and the chemical durability of the front glass plate 150 can be increased. Further, with this, the reflector 100 capable of retaining the high reflectance for a long period can be provided.

For example, the content of sodium at the first surface 152 of the front glass plate 150 may be less than or equal to 10 mol% and more preferably, less than or equal to 1 mol%.

Here, in this embodiment, "the surface of the glass plate", which is a target for determining the content of sodium, means within a range from an outermost surface of the glass plate to a depth of 10 $\mu$m. The content of sodium at such a region of the glass plate can be easily analyzed, by using Energy Dispersion X-ray spectrometry (EDX) from the glass surface, or using Electron Probe Micro Analyzer (EPMA) by cutting a sample and analyzing the sample from the surface toward the depth direction, for example.

Further, a chemical strengthening process may be performed on the first surface 152 of the front glass plate 150.

The "chemical strengthening process" is a general term for a technique to substitute alkali metal (ion) with a smaller atomic radius at an outermost surface of a glass material by alkali metal (ion) with a larger atomic radius that exists in molten salt by immersing the glass material in the molten salt including alkali metal. For example, when a chemical strengthening process is performed on the glass material including sodium (Na) in molten salt including potassium (K), sodium in the glass material is substituted by potassium.

By performing the chemical strengthening process on the glass material, compressive remaining stress occurs at the processed surface and the strength of the glass material can be increased.

Thus, by performing the chemical strengthening process on the first surface 152 of the front glass plate 150, an advantage that the strength of the front glass plate 150 is improved can be obtained.

Further, by performing the chemical strengthening process on the front glass plate 150 and substituting sodium that exists at the first surface 152 by potassium, it is possible to significantly reduce the content of sodium at the first surface 152 of the front glass plate 150 compared with the content of sodium at the third surface 112 of the support glass plate 110 even when the glasses of the same composition are used for the front glass plate 150 and the support glass plate 110. Thus, the "blur" phenomenon of the front glass plate 150 can be suppressed.

In addition to this, or besides this, the chemical strengthening process may be performed on the second surface 154 of the front glass plate 150.

When the chemical strengthening process is performed on the second surface 154 and sodium at the second surface 154 is substituted by potassium, migration of sodium ions from the front glass plate 150 to the reflection layer 140 side can be significantly suppressed. Thus, in such a case, the reflectance of the reflector 100 can be retained at a high value for a long period.

(Support glass plate 110)

The support glass plate 110 is configured by a glass substrate. The type of glass is not specifically limited, and the glass may be a soda-lime glass or the like, for example.

The transmittance of the support glass plate 110 does not influence on the reflectance of the reflector 100. Thus, the support glass plate 110 may be made thicker than the front glass plate 150. The support glass plate 110 may be made to have a thickness that the reflector 100 can have sufficient rigidity, within a range of 3 mm to 5 mm, for example.

Further, the support glass plate 110 may have the energy transmittance lower than that of the front glass plate 150.

Here, it is preferable that the transmittance of the support glass plate 110 at a wavelength region of 300 nm to 400 nm, in particular, is less than or equal to 30 %. In such a case, chemical deterioration of the adhesion layer 120 due to ultraviolet can be significantly suppressed. It is more preferable that the transmittance of the support glass plate 110 at a wavelength region of 300 nm to 400 nm is less than or equal to 20 % and further more preferably, less than or equal to 15 %.

Further, the chemical strengthening process may be performed on the first surface 112 and/or the second surface 114 of the support glass plate 110.

The shape of the support glass plate 110 is not specifically limited and is selected in accordance with the final shape of the reflector 100. For example, when the reflector 100 is adopted in a solar thermal power generation apparatus, the support glass plate 110 may have a curved surface shape such as a parabolic shape or the like. Alternatively, the support glass plate 110 may have a flat shape.

In the above example, the support glass plate 110 configured by the glass substrate is used as a support member to support the components mounted thereon. However, this is just an example. In other words, as long as the support member can support the components mounted thereon, the material of the support member is not limited to glass and the support member may be made of resin, ceramics or the like.

(Adhesion layer 120)

The adhesion layer 120 has a function to bond the front glass plate 150 on which the reflection layer 140 or the like is provided, to the support glass plate 110.

The material of the adhesion layer 120 is not specifically limited, and polyvinyl butyral (PVB), ethylene vinyl acetate (EVA), thermosetting resin, photocurable resin or the like may be used, for example.

The thickness of the adhesion layer 120 is not specifically limited, and may be within a range of 0.3 $\mu$m to 1.0 $\mu$m, for example.

(Protection layer 130)

The protection layer 130 is used for protecting the reflection layer 140 in accordance with necessity.

The protection layer 130 may be configured by metal such as copper (Cu) or the like, for example. The thickness of protection layer 130 is not specifically limited. The thickness may be within a range of 20 nm to 70 nm, for example.

(Reflection layer 140)

The reflection layer 140 is configured by a layer having high reflectivity.

The reflection layer 140 may be configured by silver or silver alloy, for example. Further, the reflection layer 140 may be configured by a stacked structure of a plurality of layers.

The reflection layer 140 may be formed by physical vapor deposition such as sputtering or the like, for example.

The thickness of the reflection layer 140 is not specifically limited, and may be within a range of 60 nm to 200 nm, for example.

(Adhesion layer)

Although not illustrated in Fig. 1, generally, an adhesion layer is provided between the front glass plate 150 and the reflection layer 140.

By providing the adhesion layer, adhesion between the front glass plate 150 and the reflection layer 140 can be improved.

The adhesion layer is configured by a layer including tin, or a mixed layer of tin and palladium, for example. Palladium functions as a catalyst of a reduction reaction of silver when forming a reflection layer including silver on the front glass plate 150. Thus, conventionally, an adhesion layer including palladium is used when forming the reflection layer including silver on the glass plate.

However, when the mixed layer of tin and palladium is used as the adhesion layer, the reflectance of the reflector 100 may be lowered. This is because palladium easily forms an alloy phase that reduces the reflectance with silver included in the reflection layer 140. However, if the adhesion layer without palladium (adhesion layer consist of tin, for example) is used, such an alloy phase is not formed and the lowering of the reflectance can be suppressed.

The reflection layer 140 is not exposed outside in a final product of the reflector 100 and is provided between the front glass plate 150 and the support glass plate 110. Thus, it is sufficient for the reflection layer 140 to have adhesion that the reflection layer 140 is not removed from the front glass plate 150 when manufacturing the reflector 100. Thus, the adhesion layer is not necessarily provided.

(Reflector 100)

The reflector 100 may be a flat shape or may be a curved surface shape and the shape of the reflector 100 may be appropriately selected based on its purpose for use.

The purpose for use of the reflector 100 is not specifically limited. For example, the reflector 100 may be appropriately adopted in application in which a high reflectance property is required. For example, the reflector 100 may be a reflector for a solar thermal power generation apparatus.

Here, generally, when a front glass plate has high mechanical strength, it is difficult to shape such a glass plate to be a desired curved surface shape with high accuracy.

However, as the reflector 100 of the example of the embodiment includes the support glass plate 110, the front glass plate 150 can be easily curved by the support glass plate 110. This means that in the reflector 100 of the example of the embodiment, by adhering the thin front glass plate 150 to the support glass plate 110 that is manufactured to have a desired curved surface shape, the front glass plate 150 can have the curved surface shape and the reflector 100 with the curved surface shape such as a parabolic reflector can be manufactured. Thus, according to the reflector 100 of the example of the embodiment, the reflector can be manufactured with high accuracy.

(Method of manufacturing reflector 100)

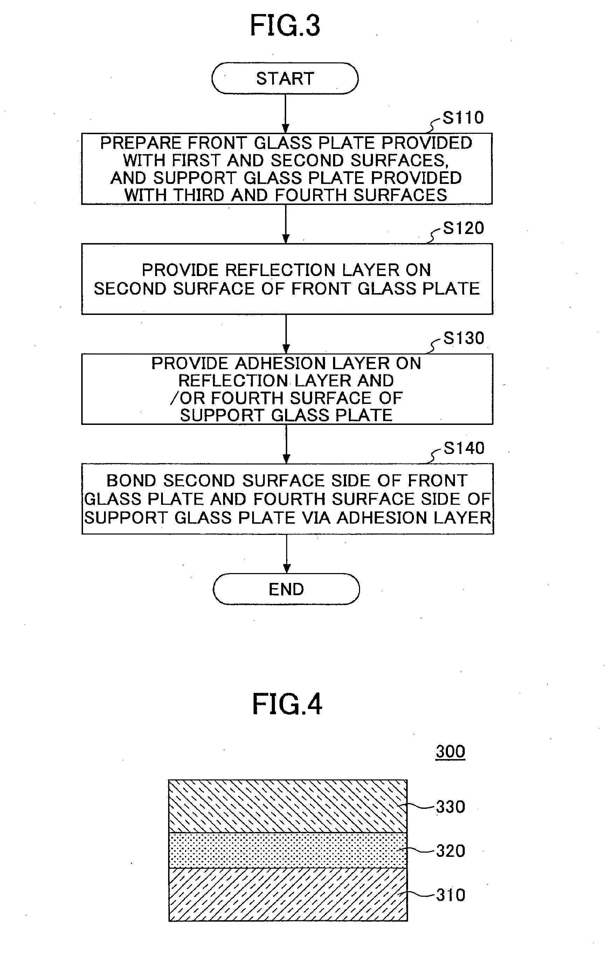

Next, with reference to Fig. 3, a method of manufacturing the reflector 100 as illustrated in Fig. 1 is explained.

In the following, a method of manufacturing the reflector 100 with a curved surface shape is explained. However, those skilled in the art will recognize that a reflector with a flat shape can be manufactured by a similar method. Further, the same reference numerals illustrated in Fig. 1 are used for each of the components.

Fig. 3 is a flowchart illustrating an example of an outline of a method of manufacturing the reflector 100.

As illustrated in Fig. 3, the method of manufacturing the reflector 100 includes,

a step (step S110) of preparing the front glass plate provided with the first and second surfaces, and the support glass plate provided with the third and fourth surfaces,

a step (step S120) of providing the reflection layer on the second surface of the front glass plate 150,

a step (step S130) of providing the adhesion layer on the reflection layer and/or the fourth surface of the support glass plate, and

a step (step S140) of bonding the second surface side of the front glass plate 150 and the fourth surface side of the support glass plate via the adhesion layer.

Each step is explained in detail in the following.

(Step S110)

First, the front glass plate 150 and the support glass plate 110 are prepared.

The front glass plate 150 is provided with the first surface 152 and the second surface 154. Further, the support glass plate 110 is provided with the third surface 112 and the fourth surface 114. The first surface 152 of the front glass plate 150 forms the light incident surface 160 of the reflector 100 after the reflector 100 is completed. The third surface 112 of the support glass plate 110 forms a back surface 172 of the reflector 100 after the reflector 100 is completed.

Here, the front glass plate 150 has features that the front glass plate 150 includes greater than or equal to 5 mol% $Al_2O_3$, in terms of an oxide, as a component and whose 50% crack initiation load is greater than or equal to 0.5 kg.

Here, as described above, the chemical strengthening process may be performed on the first surface 152 and/or the second surface 154 of the front glass plate 150.

Similarly, the chemical strengthening process may be performed on the first surface 112 and/or the second surface 114 of the support glass plate 110.

Further, the front glass plate 150 may be selected to be thinner than the support glass plate 110 and to have the energy transmittance higher than that of the support glass plate 110.

Further, the front glass plate 150 may be formed such that the content of sodium (Na) at the first surface 152 is less than that at the third surface 112 of the support glass plate 110.

The support glass plate 110 may be formed into a desired curved surface shape such as a parabolic shape or the like by a heat process or the like, for example.

(Step S120)

Next, the reflection layer 140 is provided on the second surface 154 of the front glass plate 150.

The reflection layer 140 may be directly formed on the second surface 154 of the front glass plate 150, but generally, the adhesion layer is previously provided on the second surface 154 of the front glass plate 150. With this, adhesion between the front glass plate 150 and the reflection layer 140 is improved.

The adhesion layer is configured by tin only, or a mixed layer of tin and palladium.

After the adhesion layer is formed, the reflection layer 140 made of silver or silver alloy, for example, is provided on the adhesion layer.

Further, as described above, if the adhesion layer includes palladium, the reflectance of the reflection layer 140 may be lowered. Thus, it is preferable that the adhesion layer does not include palladium.

Further after forming the reflection layer 140, the protection layer 130 may be provided on the reflection layer 140. The protection layer 130 may be configured by metal copper, or a mixture of tin chloride and silane coupling agent, for example.

(Step S130)

Next, the adhesion layer 120 is provided on the reflection layer 140 and/or on the fourth surface 114 of the support glass plate 110.

Although the structure, the material and the like of the adhesion layer 120 are not specifically limited, it is preferable that the adhesion layer 120 includes an adhesion agent.

Further, the adhesion layer is not necessarily configured by a single layer and may be configured by a plurality of layers.

(Step S140)

Next, the second surface 154 side of the front glass plate 150 and the fourth surface 114 side of the support glass plate 110 are bonded via the adhesion layer 120.

As the adhesion layer 120 is provided in step S130, the front glass plate 150 can be easily bonded to the support glass plate 110 even when the support glass plate 110 has a curved surface shape. Further, when the front glass plate 150 has a thickness less than or equal to 1 mm, the front glass plate 150 can show flexibility. Thus, the curved surface shape of the front glass plate 150 can be easily matched with the curved surface shape of the support glass plate 110.

With the above steps, the reflector 100 as illustrated in Fig. 1 can be manufactured.

The above described method of manufacturing the reflector 100 is just an example and those skilled in the art will recognize that the reflector 100 can be manufactured by another method.

(Vehicle window)

Next, an example of a vehicle window including a front glass plate of the embodiment is explained. Here, the term "vehicle window" includes any window components composed of a glass that can be used in a vehicle. For example, the "vehicle window" includes a windshield, a side glass, a roof glass and the like.

Fig. 4 is a view illustrating an example of an outline of a vehicle window including a front glass plate of the embodiment.

As illustrated in Fig. 4, the vehicle window 300 of the example of the embodiment is configured by stacking a second glass plate 310, an intermediate film 320 and the front glass plate 330 in this order. Each component is explained in detail in the following.

(Second glass plate 310)

The second glass plate 310 is configured by a glass substrate. The type of glass is not specifically limited and the glass may be a soda-lime glass or the like, for example.

Although the thickness of the second glass plate 310 is not specifically limited, it is preferable that the thickness is within a range of 2 mm to 4 mm, for example, in order to support each component mounted thereon.

The second glass plate 310 and the vehicle window 300 may have a flat shape as illustrated in Fig. 4, or alternatively, may have a curved surface shape.

(Intermediate film 320)

The intermediate film 320 has a function to bond the second glass plate 310 and the front glass plate 330. The intermediate film 320 is made of thermoplastic resin composition including thermoplastic resin as a main constituent, for example. The thickness of the intermediate film 320 is not necessarily limited but it is preferable to be 0.1 to 1.5 mm, and more preferable to be 0.2 to 1.0 mm, for example.

For the thermoplastic resin, thermoplastic resin that is conventionally used for this purpose may be used, and for example, plasticized polyvinyl acetal-based resin, plasticized polyvinyl chloride-based resin, saturated polyester-based resin, plasticized saturated polyester-based resin, polyurethane-based resin, plasticized polyurethane-based resin, ethylene-vinyl acetate copolymer-based resin, ethylene-ethylacrylate copolymer-based resin or the like may be used.

Among them, plasticized polyvinyl acetal-based resin is preferably used as it has a good balance among various properties such as transparency, weather resistance, strength, adhesion, penetration resistance, impact energy absorption, moisture proof, heat insulation, sound insulation and the like. One kind of those thermoplastic resin may be used, or two or more of those thermoplastic resin may be used in combination. The "plasticized" of the plasticized polyvinyl acetal-based resin means that the resin is plasticized by adding plasticizier, for example. This is the same for other plasticized resin.

For the polyvinyl acetal-based resin, polyvinyl formal resin obtained by reacting polyvinyl alcohol (hereinafter, referred to as "PVA" in accordance with necessity) and formaldehyde, narrow polyvinyl acetal resin obtained by reacting PVA and acetaldehyde, polyvinyl butyral resin (hereinafter, referred to as "PVB" in accordance with necessity) obtained by reacting PVA and n-butyraldehyde, or the like may be used, for example. Among them, PVB is preferably used as it has a good balance among various properties such as transparency, weather resistance, strength, adhesion, penetration resistance, impact energy absorption, moisture proof, heat insulation, sound insulation and the like. One kind of those polyvinyl acetal-based resin may be used, or two or more of those polyvinyl acetal-based resin may be used.

For the plasticizier, for example, organic acid ester-based plasticizier such as monobasic organic acid ester-based, polybasic organic acid ester-based or the like, phosphate-based plasticizier such as organic phosphate-based, organic phosphorous-based or the like, or the like may be used. Although the additional amount of the plasticizier is different based on the average degree of polymerization of the thermoplastic resin, the average degree of polymerization, the degree of acetalization and the amount of remaining acetyl group of the polyvinylacetal-based resin or the like, it is preferable that the additional amount is 10 to 80 mass parts with respect to 100 mass parts of thermoplastic resin. When the additional amount of the plasticizier is less than 10 mass parts, the thermoplastic resin is not sufficiently plasticized and it may be difficult to shape. Further, when the additional amount of the plasticizier is more than 80 mass parts, the strength may be insufficient.

The thermoplastic resin composition may include infrared rays shielding agent. For the infrared rays shielding agent, metal such as Re, Hf, Nb, Sn, Ti, Si, Zn, Zr, Fe, Al, Cr, Co, Ce, In, Ni, Ag, Cu, Pt, Mn, Ta, W, V, Mo or the like, oxide, nitride, sulfide or silicide of them, or inorganic particles in which dopant such as Sb, F, Sn or the like is doped to them may be used, for example. Specifically, tin oxide particles doped with Sb (ATO particle) or indium oxide particles doped with Sn (ITO particle) may be used, and among these, ITO particles are preferably used.

The thermoplastic resin composition may include one or more of various additives such as adhesive regulator, coupling agent, surfactant, antioxidant, heat stabilizer, photostabilizer, ultraviolet absorber, fluorescent, dehydrating agent, antifoaming agent, antistatic agent, flame retardant or the like in addition to the thermoplastic resin, and the infrared rays shielding agent that is added in accordance with necessity.

(Front glass plate 330)

The front glass plate 330 may be configured by any types of glass provided that the front glass plate 330 has the above described features (1) and (2). For example, the front glass plate 330 may be a front glass plate like the front glass plate 150 that is used in the above described reflector 100.

For the structure of the front glass plate 330, the structure described for the above described front glass plate 150 can be adopted. Thus, the structure of the front glass plate 330 is not explained here.

The vehicle window 300 of the example of the embodiment includes the front glass plate 330 that has the above described features (1) and (2). Thus, the vehicle window 300 of the example of the embodiment can significantly improve the mechanical and chemical characteristics, compared with a conventional one.

Those skilled in the art will recognize a method of manufacturing the vehicle window 300 based on the description of the above described method of manufacturing the reflector or the like. Thus, a method of manufacturing the vehicle window 300 is not specifically explained.

(Solar photovoltaic module)

Next, an example of a solar photovoltaic module including a front glass plate of the embodiment is explained.

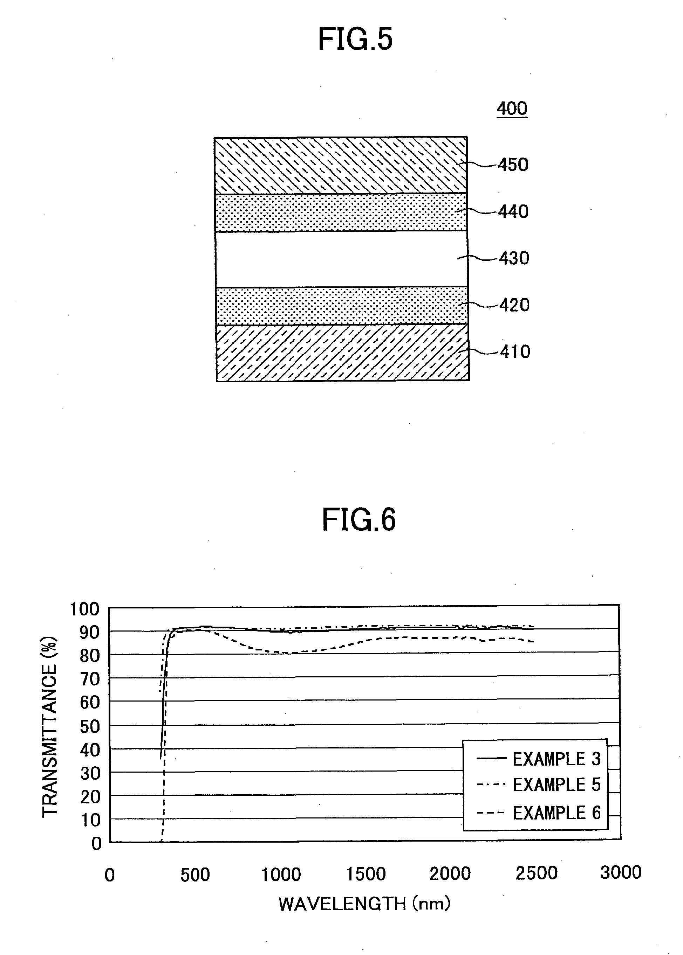

Fig. 5 is a view illustrating an example of an outline of a solar photovoltaic module 400 including a front glass plate of the embodiment.
As illustrated in Fig. 5, the solar photovoltaic module 400 of the example of the embodiment is configured by a support member 410, a first sealing material 420, a solar cell 430, a second sealing material 440 and the front glass plate 450. Each component is explained in detail in the following.

(Support member 410)

The support member 410 is configured by a resin sheet or a glass substrate.
When the support member 410 is configured by a glass substrate, the type of glass is not specifically limited and the glass may be a soda-lime glass or the like, for example.
The thickness of the support member 410 is not specifically limited.
The shape of the support member 410 is not specifically limited and is selected in accordance with the final shape of the solar photovoltaic module 400. The support member 410 may have a curved surface shape, for example. Alternatively, the support member 410 may have a flat shape.

(First sealing material 420 and second sealing material 440)

The first sealing material 420 and the second sealing material 440 may be configured by any materials provided that they can seal the solar cell 430. The first sealing material 420 and the second sealing material 440 may be configured by resin or the like such as ethylene vinyl acetate (EVA) or the like, for example.

(Solar cell 430)

The solar cell 430 is not specifically limited, and various solar cells capable of generating a potential difference in a solar photovoltaic module included therein may be used. For the kind of the solar cell, a crystalline silicon solar photovoltaic module, a thin film silicon solar photovoltaic module, a thin film compound solar photovoltaic module (CdTe, CI(G)S, CZTS), an organic thin film solar photovoltaic module, a dye-sensitization solar photovoltaic module, a high-efficiency compound solar photovoltaic module or the like may be used, for example. For the crystalline silicon solar photovoltaic module, monocrystal silicon, polycrystal silicon, heterojunction (amorphous/ crystalline silicon: so-called HIT) or the like may be used.

(Front glass plate 450)

The front glass plate 450 may be made of any types of glass provided that the front glass plate 450 has the above described features (1) and (2). For example, the front glass plate 450 may be a front glass plate like the front glass plate 150 or 330 that is used in the above described reflector 100 or the vehicle window 300.
For the structure of the front glass plate 450, the structure described for the above described front glass plate 150 can be adopted. Thus, the structure of the front glass plate 450 is not explained here.
The solar photovoltaic module 400 of the example of the embodiment includes the front glass plate 450 that has the above described features (1) and (2). Thus, the solar photovoltaic module 400 of the example of the embodiment can significantly improve the mechanical and chemical characteristics, compared with a conventional one.
Those skilled in the art will recognize a method of manufacturing the solar photovoltaic module 400 based on the description of the above described method of manufacturing the reflector or the like. Thus, a method of manufacturing the solar photovoltaic module 400 is not specifically explained.

[Examples]

Next, examples of the embodiment are explained.
As illustrated in examples 1 to 4 below, samples of the front glass plates of various compositions were manufactured and their properties were evaluated.

(Example 1)

First, a glass sample (a glass sample of an example 1) of an aluminosilicate glass having the composition as illustrated in the item of "example 1" in Table 1, in terms of an oxide, was manufactured.

[Table 1]

| (mol%) | EXAMPLE 1 | EXAMPLE 2 | EXAMPLE 3 | EXAMPLE 4 | EXAMPLE 5 | EXAMPLE 6 |
|---|---|---|---|---|---|---|
| $SiO_2$ | 72.5 | 64.2 | 66.1 | 70.1 | 64.2 | 70.1 |
| $Al_2O_3$ | 6.2 | 8.0 | 11.3 | 1.1 | 8.0 | 1.1 |
| $B_2O_3$ | - | - | 7.6 | - | - | - |
| MgO | 8.5 | 10.5 | 5.3 | 7.1 | 10.5 | 7.1 |
| CaO | - | 0.1 | 4.8 | 8.5 | 0.1 | 8.5 |
| SrO | - | 0.1 | 4.9 | - | 0.1 | - |
| BaO | - | 0.1 | - | - | 0.1 | - |
| $Li_2O$ | - | - | - | - | - | - |
| $Na_2O$ | 12.8 | 12.5 | - | 13.2 | 12.5 | 13.2 |
| $K_2O$ | - | 4.0 | - | 0.05 | 4.0 | 0.05 |
| $ZrO_2$ | - | 0.5 | - | - | 0.5 | - |
| $Fe_2O_3$ | 0.015 | 0.020 | 0.055 | 0.010 | 0.020 | 0.010 |
| DENSITY (g/cm$^3$) | 2.41 | 2.48 | 2.51 | 2.49 | 2.48 | 2.49 |
| Tg(°C) | 627 | 604 | 710 | 550 | 604 | 550 |
| SOFTENING POINT(°C) | 856 | 831 | 950 | 733 | 831 | 733 |
| VI CKERS HARDNESS | 561 | 599 | 580 | 533 | 599 | 533 |
| THICKNESS (mm) | 0.6 | 0.5 | 0.7 | 3.9 | 0.8 | 3.0 |

The thickness of the glass sample was 0.6 mm.
For the glass sample, the density was 2.41 g/cm$^3$, the glass-transition temperature (Tg) was 627 °C and the softening point was 856 °C. Further, the Vickers hardness of the glass sample was 561.

(Example 2)

A glass sample (a glass sample of an example 2) of an aluminosilicate glass having the composition as illustrated in the item of "example 2" in Table 1 was manufactured.
The thickness of the glass sample was 0.5 mm.
For the glass sample, the density was 2.48 g/cm$^3$, the glass-transition temperature (Tg) was 604 °C and the softening point was 831 °C. Further, the Vickers hardness of the glass sample was 599.

(Example 3)

A glass sample (a glass sample of an example 3) of an alkali-free borosilicate glass having the composition as illustrated in the item of "example 3" in Table 1 was manufactured.
The thickness of the glass sample was 0.7 mm.
For the glass sample, the density was 2.51 g/cm$^3$, the glass-transition temperature (Tg) was 710 °C and the softening point was 950 °C. Further, the Vickers hardness of the glass sample was 580.

(Example 4)

A glass sample (a glass sample of an example 4) of a soda-lime glass having the composition as illustrated in the item of "example 4" in Table 1 was manufactured.

The thickness of the glass sample was 3.9 mm.

For the glass sample, the density was 2.49 g/cm$^3$, the glass-transition temperature (Tg) was 550 °C and the softening point was 733 °C. Further, the Vickers hardness of the glass sample was 533.

(Example 5)

A glass sample (a glass sample of an example 5) of an aluminosilicate glass having' the composition (in terms of the oxide value) as illustrated in the item of "example 5" in Table 1 was manufactured.

The thickness of the glass sample was 0.8 mm.

For the glass sample, the density was 2.48 g/cm$^3$, the glass-transition temperature (Tg) was 604 °C and the softening point was 831 °C. Further, the Vickers hardness of the glass sample was 599.

Next, a chemical strengthening process was performed on both surfaces of the glass sample.

The chemical strengthening process was performed, without masking the glass sample, by immersing the entirety of the glass sample in molten salt of potassium nitrate.

The process temperature (molten salt temperature) was 435 °C and the process time (immersing time) was 90 minutes.

With this, sodium ions were substituted by potassium ions at both surfaces of the glass sample and the glass sample of example 5 was obtained.

The content of sodium at a surface (the surface on which the chemical strengthening process was performed) of the glass sample of example 5 was analyzed. EPMA was used for analysis.

As a result of the analysis, at the surface of the glass sample of example 5, the content of Na$_2$O was 6 mol%, in terms of an oxide, and the content of K$_2$O was 10.5 mol%, in terms of an oxide. As the content of Na$_2$O at the surface of the glass sample before the chemical strengthening process was 12.5 mol%, in terms of an oxide, it was confirmed that sodium ion was substituted by potassium ion by the chemical strengthening process.

(Example 6)

A glass sample (a glass sample of an example 6) of a soda-lime glass having the composition as illustrated in the item of "example 6" in the above described Table 1 was manufactured.

The thickness of the glass sample was 3.0 mm.

For the glass sample, the density was 2.49 g/cm$^3$, the glass-transition temperature (Tg) was 550 °C and the softening point was 733 °C.

The composition of the glass sample of example 6 is substantially the same as that of the above described glass sample of example 4 and only the thickness is different.

In Table 1, density, glass-transition temperature, softening point, Vickers hardness and thickness of the glass samples of examples 1 to 6 are illustrated. The values (including the composition) of the glass sample of example 5 are values before performing the chemical strengthening process.

(Evaluation)

Next, various evaluations were performed using the glass samples of examples 1 to 6.

(Measurement of energy transmittance)

First, energy transmittance was measured using the glass samples of examples 1 to 6. The energy transmittance was measured by an apparatus called LAMBDA95 (manufactured by PerkinElmer Inc.).

As a result of the measurement, the energy transmittance of the glass sample of example 1 was 91.8 % and the glass sample of example 1 showed good transparency. Further, the energy transmittances of the glass samples of examples 2 and 3 were 91.5 % and 90.4 %, respectively. The glass samples of examples 2 and 3 showed good transparency. On the other hand, the energy transmittance of the glass sample of example 4 was 90.3 % and it was the lowest transparency among the glass samples of examples 1 to 4.

Further, the energy transmittance of the glass sample of example 5 was 91.5 % and the glass sample of example 5 showed good transparency. However, the energy transmittance of the glass sample of example 6 was 90.3 % and showed low transparency.

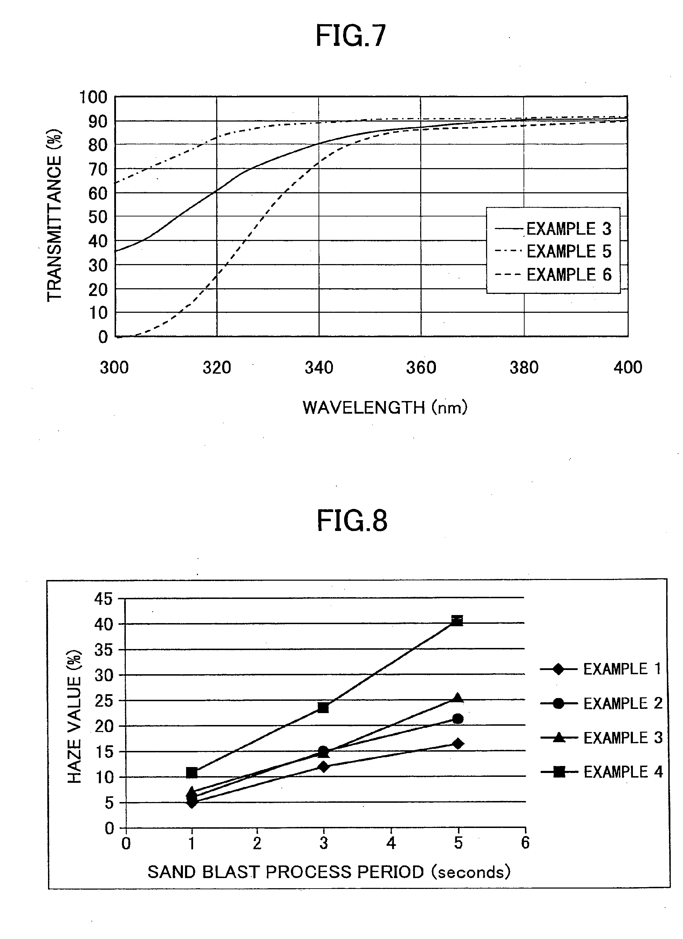

The measurement result of the transmittances of the glass samples of examples 3, 5 and 6 is illustrated in Fig. 6 and Fig. 7. Fig. 6 illustrates the measurement result of the transmittances at wavelength from 300 nm to 2500 nm. Fig. 7 is an enlarged graph of a part of the wavelength from 300 nm to 400 nm.

From the measurement result, it can be understood that the glass samples of examples 3 and 5 have good transmittances at a wide range of wavelength from about 400 nm to about 2500 nm.

In particular, as illustrated in Fig. 7, it can be understood that the glass samples of examples 3 and 5 retain significantly high transmittance at the region of wavelength from 300 nm to 400 nm. Thus, when the glass samples of examples 3 and 5 are used for the front glass plate of the reflector, it is possible to use spectrum of ultraviolet region of sunlight and it is considered that a reflector with extremely high reflectivity can be provided.

On the other hand, the glass sample of example 6 had lower transmittance compared with the glass samples of examples 3 and 5. In particular, the glass sample of example 6 had a tendency that the transmittance at the region of wavelength from 300 nm to 400 nm was significantly decreased.

With the above result, when the glass sample of example 1, 2, 3 or 5 is used for the front glass plate of the reflector, compared with a case when the glass sample of example 4 or 6 is used as the front glass plate of the reflector, it is expected that a reflector with high reflectance can be obtained.

(Measurement of 50% crack initiation load)

Next, using the glass samples of examples 1 to 4, the 50% crack initiation load was measured. The method of measuring the 50% crack initiation load is as described above.

As a result of the measurement, the 50% crack initiation load of the glass sample of example 1 became about 1 to 2 kgf. Similarly, the 50% crack initiation load of the glass samples of examples 2 and 3 became about 0.5 kgf and about 1 to 2 kgf, respectively. On the other hand, the 50% crack initiation load of the glass sample of example 4 became about 0.1 to 0.2 kgf.

As such, the 50% crack initiation load of the glass samples of examples 1 to 3 indicated relatively large values, and it was revealed that these glass samples were not so fragile. With this, it is predicted that relatively good mechanical characteristics are obtained when the glass samples of examples 1 to 3 are used as the front glass plate for the stacked structure.

On the other hand, the 50% crack initiation load of the glass sample of example 4 was significantly low compared with the other glass samples, and it was revealed that the glass sample of example 4 was relatively fragile. Thus, it is predicted that mechanical characteristics are not so good when the glass sample of example 4 is used as the front glass plate for the stacked structure.

(Evaluation of erosion-resistance)

Next, erosion-resistance of each of the glass samples of examples 1 to 4 were evaluated. The erosion-resistance was measured by measuring a haze value of each of the glass samples after performing the sand blast process.

The sand blast process was performed by irradiating alumina medium of a particle size #80 toward the glass sample in a substantially perpendicular direction with a pressure of 1 kg/cm$^2$. The distance between the glass sample and the blast gun was 35 cm. Further, the haze value was measured by a haze meter.

Fig. 8 illustrates a relationship between a sand blast process period and a haze value obtained for each of the glass samples of examples 1 to 4.

As illustrated in Fig. 8, in any of the glass samples, the haze value increased in accordance with increasing of the sand blast process period. However, for the glass samples of examples 1 to 3, even after the sand blast process of five seconds, the haze value is retained at about less than or equal to 25 %. On the other hand, for the glass sample of example 4, after the sand blast process of five seconds, the haze value increased to about 40 %. Further, for the glass sample of example 4, at any sand blast process periods, the haze value expressed the maximum value.

With this result, it was revealed that although the glass samples of examples 1 to 3 have relatively good erosion-resistance, the glass sample of example 4 does not have good erosion-resistance. Thus, it is expected that by using the glass samples of examples 1 to 3 as the front glass plate for the stacked structure, relatively good erosion-resistance can be obtained.

(Evaluation of chemical stability)

Next, chemical stabilities of the glass samples of examples 2 to 4 were evaluated. The chemical stability was evaluated by measuring a haze value of each of the glass samples after the sample was retained at high temperature in a high humidity environment for a long period.

In order to retain the glass samples of examples 2 to 4 at high temperature in a high humidity environment, each of the glass samples was placed in a thermostatic oven at temperature of 65 °C with a relative humidity of 95 %. Each of the glass samples was taken out from the thermostatic oven after a predetermined period and the haze value was measured. The haze value was measured by a haze meter.

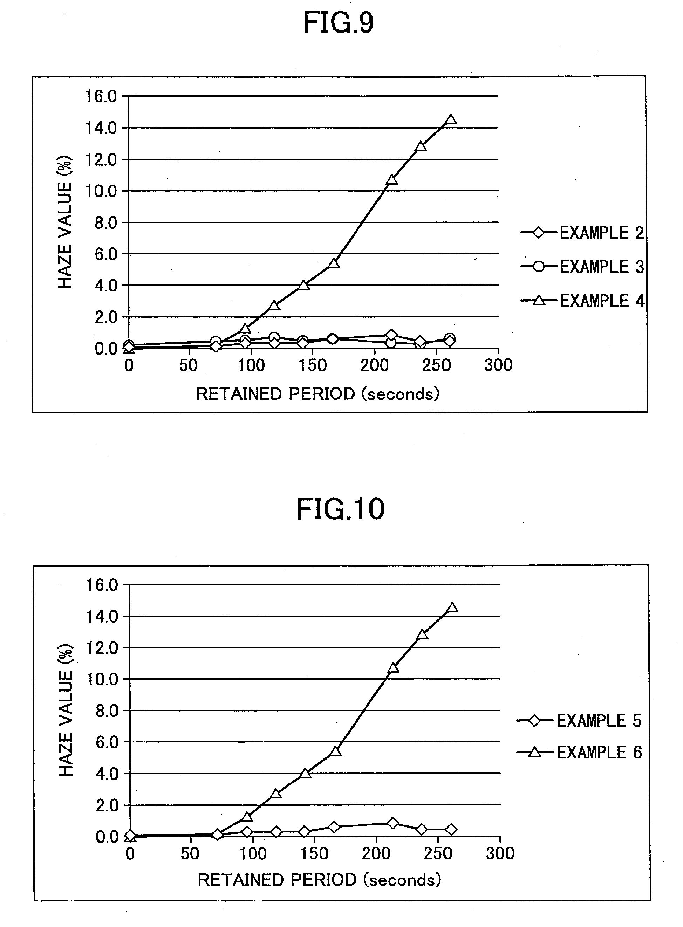

Fig. 9 illustrates a measurement result obtained in each of the glass samples. In Fig. 9, the axis of abscissas indicates a retained period and the axis of ordinates indicates a haze value.

It can be understood from Fig. 9 that for the glass samples of examples 2 and 3, the haze values did not change after 250 hours and the haze values were kept at low values. On the other hand, for the glass sample of example 4, after about 70 hours, the haze value was observed to increase and thereafter, showed a tendency that the haze value significantly increased in accordance with the retained period.

The same measurement was performed on the glass samples of examples 5 and 6.

Fig. 10 illustrates the result. It can be understood from Fig. 10 that for the glass sample of example 5, the haze value did not change after 250 hours and the haze value was kept at a low value. On the other hand, for the glass sample of example 6, similar to the glass sample of example 4, after about 70 hours, the haze value was observed to increase and thereafter, showed a tendency that the haze value significantly increased in accordance with the retained period.

With this result, it was revealed that the glass samples of examples 2, 3 and 5 were relatively chemically stable, but the glass samples of examples 4 and 6 did not have good chemical stabilities. Thus, by using the glass sample of example 2, 3 or 5 as the front glass plate for the stacked structure, the front glass plate by which the "blur" phenomenon does not easily occur and which is relatively chemically stable can be provided.

Various evaluated results obtained for the glass samples of examples 1 to 6 are illustrated in the following Table 2.

[Table 2]

| | ENERGY TRANSMIT-TANCE (%) | 50% CRACK INITIATION LOAD (kgf) | HAZE VALUE AFTER THREE SECONDS SAND BLAST PROCESS (%) | HAZE VALUE AFTER HIGH TEMPERATURE AND HIGH HUMIDITY TEST (%) |
|---|---|---|---|---|
| EXAMPLE 1 | 91.8 | 1~2 | 11.9 | - |
| EXAMPLE 2 | 91.5 | 0.5 | 14.7 | 0.5 |
| EXAMPLE 3 | 90.4 | 1~2 | 15.0 | 0.6 |
| EXAMPLE 4 | 90.3 | 0.1~0.2 | 23.7 | 14.8 |
| EXAMPLE 5 | 91.5 | - | - | 0.5 |
| EXAMPLE 6 | 90.3 | - | - | 14.8 |

Here, the chemical stability was not evaluated for the glass sample of example 1. However, as the composition and the physical property of the glass sample of example 1 are relatively close to those of the glass sample of example 2, it can be considered that the glass sample of example 1 can have the chemical stability similar to that of the glass sample of example 2.

(Examples 7 to 9)

Next, as materials for the support glass plate, glass samples of the following examples 7 to 9 were prepared and their characteristic properties were evaluated.

First, three kinds of glass plates made of a deep colored soda-lime glass having different thicknesses were prepared.

Hereinafter, the glass plate made of a deep colored soda-lime glass having a thickness of 3.2 mm is referred to as a "glass sample of example 7". Further, the glass plate made of a deep colored soda-lime glass having a thickness of 4.0 mm is referred to as a "glass sample of example 8". Further, the glass plate made of a deep colored soda-lime glass having a thickness of 5.0 mm is referred to as a "glass sample of example 9".

Next, transmittances of the glass samples of examples 7 to 9 were measured.

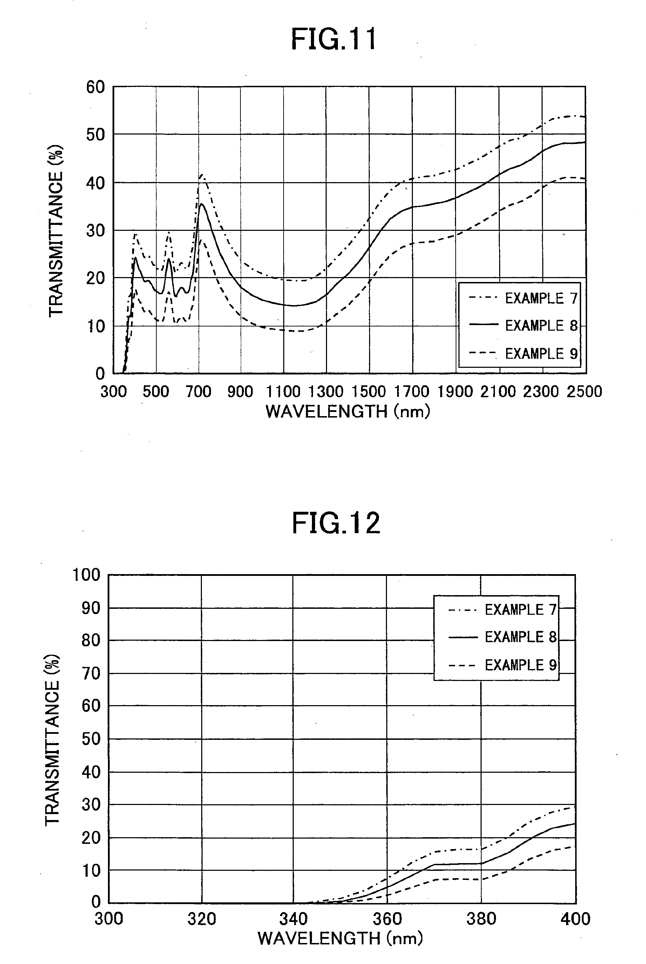

The measurement result of the transmittances of the glass samples of examples 7 to 9 are illustrated in Fig. 11 and Fig. 12. Fig. 11 illustrates the measurement result of the transmittances at wavelength from 300 nm to 2500 nm. Fig. 12 is an enlarged graph of a part of the wavelength from 300 nm to 400 nm.

It can be understood From Fig. 11 that the transmittance between 300 nm to 2500 nm is not so high for the glass samples of examples 7 to 9. The energy transmittances of the glass samples of examples 7 to 9 were calculated based on the obtained result. As a result, the energy transmittances of the glass samples of examples 7 to 9 were 26.8 %, 21.4 % and 15.0 %, respectively.

With these results, the glass samples of examples 7 to 9 do not have good transmittance and are not appropriate to be used as the front glass plate of the reflector.

Here, for any the glass samples of examples 7 to 9, the transmittances at wavelength from 300 nm to 400 nm are extremely low. For example, for the glass sample of example 7, the transmittance at wavelength from 300 nm to 400 nm is less than 30 % at most. Similarly, for the glass samples of examples 8 and 9, the transmittances at the region are less than 25 % and less than 20 %, respectively.

Thus, it can be said that the glass samples of examples 7 to 9 are extremely adoptable for the support glass plate of the reflector.

It means that when the glass samples of examples 7 to 9 are used as the support glass plate of the reflector, ultraviolet region spectrum included in external light can be significantly blocked. Thus, when the glass samples of examples 7 to 9 are used as the support glass plate of the reflector, chemical deterioration of the adhesion layer can be significantly suppressed and it is expected that a reflector capable of suppressing deterioration of the adhesion layer for a long period can be provided.

The present invention can be adopted as, for example, a front glass or the like used in a building window glass, a vehicle window glass, a cover glass for a solar photovoltaic module or the like.

Although a preferred embodiment of the present invention has been specifically illustrated and described, the present invention is not limited to the specifically disclosed embodiments, and numerous variations and modifications may be made without departing from the spirit and scope of the present invention.

The present application is based on and claims the benefit of priority of Japanese Priority Application No. 2012-110088 filed on May 11, 2012, Japanese Priority Application No. 2012-110089 filed on May 11, 2012 and Japanese Priority Application No. 2013-026354 filed on February 14, 2013 and the entire contents of which are hereby incorporated by reference.

**Claims**

1. A front glass plate for a stacked structure, the front glass plate comprising:

   greater than or equal to 5 mol% of $Al_2O_3$, in terms of an oxide, as a component,
   50% crack initiation load of the front glass plate being greater than or equal to 0.5 kg.

2. The front glass plate according to claim 1, further comprising MgO.

3. The front glass plate according to claim 2, wherein greater than or equal to 5 mol% of MgO, in terms of an oxide, is included.

4. The front glass plate according to any one of claims 1 to 3, further comprising $B_2O_3$.

5. The front glass plate according to any one of claims 1 to 4,
   wherein energy transmittance of the front glass plate is greater than or equal to 90.4 %.

6. The front glass plate according to any one of claims 1 to 5,
   wherein a haze value of the front glass plate after having performed a sand blast process for three seconds is less than or equal to 15 %.

7. The front glass plate according to any one of claims 1 to 6,
   wherein at least a surface of the front glass plate is chemical strengthened.

8. A stacked structure comprising:

   the front glass plate according to any one of claims 1 to 7; and
   a functional component provided at a back surface of the front glass plate.

9. The stacked structure according to claim 8,
   wherein the functional component is at least one selected from a group consisting of an intermediate film, a solar cell and a reflection layer.

**10.** The stacked structure according to claim 8 or 9, further comprising:

a second glass plate provided at a surface of the functional component opposite to the front glass plate.

**11.** The stacked structure according to claim 10,
wherein a thickness of the front glass plate is less than or equal to a thickness of the second glass plate.

**12.** The stacked structure according to claim 10 or 11,
wherein the energy transmittance of the front glass plate is higher than or equal to the energy transmittance of the second glass plate.

**13.** The stacked structure according to any one of claims 10 to 12,
wherein the front glass plate is provided with a first surface that is at a further side from the second glass plate and a second surface that is at a closer side from the second glass plate,
wherein the second glass plate is provided with a third surface that is at a further side from the front glass plate and a fourth surface that is at a closer side from the front glass plate, and
wherein the content of sodium (Na) at the first surface of the front glass plate is less than or equal to the content of sodium (Na) at the third surface of the second glass plate.

**14.** The stacked structure according to any one of claims 10 to 13,
wherein the second glass plate is not chemical strengthened.

**15.** The stacked structure according to any one of claims 10 to 13,
wherein the second glass plate is chemical strengthened.

**16.** The stacked structure according to any one of claims 8 to 15,
wherein the stacked structure has a curved surface shape.

**17.** The front glass plate according to claim any one of claims 7 to 16,
wherein a thickness of the front glass plate is less than or equal to 1 mm.

**18.** The stacked structure according to claim 8,
wherein a thickness of the front glass plate is less than or equal to 1 mm.

# FIG.1

# FIG.2

# FIG.3

```
           ┌─────────────┐
           │    START    │
           └──────┬──────┘
                  │           ⟋S110
  ┌───────────────▼─────────────────┐
  │ PREPARE FRONT GLASS PLATE PROVIDED│
  │  WITH FIRST AND SECOND SURFACES, │
  │  AND SUPPORT GLASS PLATE PROVIDED│
  │   WITH THIRD AND FOURTH SURFACES │
  └───────────────┬─────────────────┘
                  │           ⟋S120
  ┌───────────────▼─────────────────┐
  │      PROVIDE REFLECTION LAYER ON │
  │ SECOND SURFACE OF FRONT GLASS PLATE│
  └───────────────┬─────────────────┘
                  │           ⟋S130
  ┌───────────────▼─────────────────┐
  │      PROVIDE ADHESION LAYER ON   │
  │         REFLECTION LAYER AND     │
  │        /OR FOURTH SURFACE OF     │
  │         SUPPORT GLASS PLATE      │
  └───────────────┬─────────────────┘
                  │           ⟋S140
  ┌───────────────▼─────────────────┐
  │  BOND SECOND SURFACE SIDE OF FRONT│
  │GLASS PLATE AND FOURTH SURFACE SIDE OF│
  │SUPPORT GLASS PLATE VIA ADHESION LAYER│
  └───────────────┬─────────────────┘
                  │
           ┌──────▼──────┐
           │     END     │
           └─────────────┘
```

# FIG.4

300

330
320
310

# FIG.5

400

450
440
430
420
410

# FIG.6

EXAMPLE 3
EXAMPLE 5
EXAMPLE 6

# FIG.7

# FIG.8

# FIG.9

# FIG.10

## FIG.11

## FIG.12

## INTERNATIONAL SEARCH REPORT

International application No.

PCT/JP2013/062275

### A. CLASSIFICATION OF SUBJECT MATTER
*C03C3/087*(2006.01)i, *B32B17/06*(2006.01)i, *C03C3/085*(2006.01)i, *C03C3/091*(2006.01)i, *G02B5/08*(2006.01)i, *G02B5/10*(2006.01)i

According to International Patent Classification (IPC) or to both national classification and IPC

### B. FIELDS SEARCHED

Minimum documentation searched (classification system followed by classification symbols)
C03C1/00-14/00, H01L31/04-31/052

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2013 |
| Kokai Jitsuyo Shinan Koho | 1971-2013 | Toroku Jitsuyo Shinan Koho | 1994-2013 |

Electronic data base consulted during the international search (name of data base and, where practicable, search terms used)
INTERGLAD

### C. DOCUMENTS CONSIDERED TO BE RELEVANT

| Category* | Citation of document, with indication, where appropriate, of the relevant passages | Relevant to claim No. |
|---|---|---|
| X<br>Y | JP 2011-241143 A  (Nippon Electric Glass Co., Ltd.),<br>01 December 2011 (01.12.2011),<br>claims; paragraphs [0028], [0076]; sample no.17, 18<br>& US 2009/0197088 A1    & EP 2177485 A1<br>& WO 2009/019965 A1    & KR 10-2010-0057594 A<br>& CN 101772470 A | 1-9,16-18<br>10-15 |
| Y | JP 2011-222752 A  (Hitachi Chemical Co., Ltd.),<br>04 November 2011 (04.11.2011),<br>paragraphs [0002], [0003]; fig. 2<br>(Family: none) | 10-15 |

☐ Further documents are listed in the continuation of Box C.     ☐ See patent family annex.

| | |
|---|---|
| * Special categories of cited documents:<br>"A" document defining the general state of the art which is not considered to be of particular relevance<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| | |
|---|---|
| Date of the actual completion of the international search<br>11 July, 2013 (11.07.13) | Date of mailing of the international search report<br>23 July, 2013 (23.07.13) |
| Name and mailing address of the ISA/<br>Japanese Patent Office | Authorized officer |
| Facsimile No. | Telephone No. |

Form PCT/ISA/210 (second sheet) (July 2009)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 7871664 B
- JP 2012110088 A
- JP 2012110089 A
- JP 2013026354 A